# EUROPEAN PATENT APPLICATION

(11) **EP 1 280 009 A2**
(43) Date of publication of application: **29.01.2003**
(21) Application number: 02255239.2
(22) Date of filing: 26.07.2002
(51) Int. Cl.: G03F 7/20

(54) **Photolithographic structuring method**

(30) Priority: 27.07.2001 US 916710
(71) Applicant: Hewlett-Packard Company, Palo Alto, CA 94304 (US)
(72) Inventor: Arifin, Juliana, Singapore 267913 (SG); Tran, Thinh Van, San Jose, CA 95123 (US)
(74) Representative: Powell, Stephen David

(57) **Abstract**

A structuring method for stepped wafer or die surfaces, includes photolithographically exposing a pattern comprising at least a first pattern portion and a second pattern portion onto a surface, said surface comprising at least a first surface portion at which a tangential plane to the surface extends in a first plane and a second surface portion at which a tangential plane to the surface extends in a second plane not coinciding with the first plane. The method comprises a first exposure step, in which the first pattern portion is exposed. Therein, the first pattern portion (51, 61) is focused into a first focal plane. The method further comprises a second exposure step, in which the second pattern portion (52, 62) is exposed. Therein, the second pattern portion is focused into a second focal plane which is different from the first focal plane.

## Description

The invention relates to a structuring method including photolithographic exposure of a pattern onto a nonplanar surface being structured perpendicular to the surface and a die which has been fabricated using the structuring method.

The fabrication of high topography semiconductor devices from a wafer includes a great number of processing steps, such as photolithography and material deposition or application steps. After a number of processing steps have been performed to generate a semi-processed wafer, the originally planar wafer surface usually has become highly nonplanar. For example, the surface of the semi-processed wafer comprises a structure of plateau-like planar regions at different levels and sloping step regions connecting the different plateau-like planar regions.

An example for a nonplanar semi-processed wafer is a stepped wafer which has a surface having an array of parallel trenches. Each trench has a planar bottom face extending in a first plane at a bottom level. A planar top face extending in a second plane at a top level, which is higher than the bottom level, is located between each two adjacent bottom faces. Each top face is connected to each adjacent bottom face via a sloping step face acting as a side wall of the respective trench.

Due to the nonplanar surface of the semi-processed wafer, a further photolithographic processing of the wafer is difficult.
In a known photolithographic processing step, the wafer surface to be processed is coated by a photo-sensitive resist. Then, a photolithographic device projects a pattern of light, e.g. UV- light, onto the resist coating and thus exposes the pattern into the resist coating. A development step follows, in which, depending on the properties of the resist used, either all exposed or all unexposed resist regions are removed. By this, the exposed pattern has been transferred into the resist coating.

Further processing steps can follow, wherein the patterned resist is used as a mask, e.g. for an etching process or for a material deposition or application process. For example, a metal structure having a shape corresponding to the exposed pattern can be generated by a deposition or application step. A sputtering or similar technique or a vapor deposition technique can be used for deposition.

The resist is completely exposed only in the case, when the pattern is focused such that the focal plane of the light used for exposure coincides with the plane of the resist coating, i.e. when a sharp image of the pattern is generated in the plane of the resist coating. According to this consideration, only perfectly planar surfaces can be photolithographically exposed.

Realistically, a sufficiently sharp image of the pattern is achieved not only in a single plane having zero height along the direction of propagation of the exposure light, but in a spatial region having a finite height along said direction of propagation. Said height is determined by the depth of focus of the photolithographic device.

For this reason, also nonplanar wafer surfaces having variations in surface level can be photolithographically exposed, as long as the variations in surface level are not too large. Therein, the depth of focus of the photolithographic device determines the maximum allowed variations in surface level, so that a sufficient exposure of all wafer regions is still achieved.

A sufficient exposure of all wafer regions to be exposed is also essential for following etching and deposition (application) steps, for example for generating uninterrupted conducting traces. In wafer regions in which the resist is underexposed, the projected pattern is possibly not completely transferred into the resist. Resist remainders can remain at locations where the resist should have been removed. Therefore, a metal film deposited in a deposition step following the exposure can be accidentally interrupted in the underexposed regions due to the resist remainders.

To solve the problem of achieving a sufficient exposure also for highly nonplanar wafer surfaces, the depth of focus of the photolithographic device can be increased. An increase in the depth of focus however leads to a decrease in resolution. However, what is desired in photolithography is a further increase in resolution, so as to achieve more detailed structures.

In other known wafer processing concepts for nonplanar wafer surfaces the amount of the variations in surface level of the wafer is reduced. For this reason, the use of a photolithographic device having a low depth of focus is possible, while a sufficient exposure of the entire wafer surface is achieved due to the reduced amount of the variations in surface level.

It is an object of the present invention to provide a structuring method which allows a photolithographic exposure of a nonplanar surface having large variations in surface level between different surface regions of the surface. It is a particular object of the present invention to provide a structuring method which allows a fabrication of uninterrupted conductive traces on a nonplanar surface having large variations in surface level between different surface regions of the surface by means of an adequate photolithography technique.

This object is achieved by a structuring method, including photolithographically exposing a pattern comprising at least a first pattern portion and a second pattern portion onto a surface, said surface comprising at least a first surface portion at which a tangential plane to the surface extends in a first plane and a second surface portion at which a tangential plane to the surface extends in a second plane not coinciding with the first plane, the method comprising
a first exposure step, in which the first pattern portion is exposed, therein being focused into a first focal plane, and
a second exposure step, in which the second pattern portion is exposed, therein being focused into a second focal plane which is different from the first focal plane.

The use of two separated exposure steps with two different focal planes allows a reliable exposure of the structured surface, even if it is highly nonplanar and has structural features which have a mutual distance in the direction of propagation of the exposure light which is larger than the depth of focus of the device used for the exposure.

The method according to the invention is particularly suited for stepped surfaces having parallel planar faces at two or more different levels. For a two-level surface having a planar top face extending in a top first plane and a planar bottom face extending in a bottom second plane which is parallel to and not coinciding with the first plane, the first exposure step can be performed with the first pattern portion being focused onto the top face; the second exposure step can be performed with the second pattern portion being focused onto the bottom face.

Optionally, the photolithographic exposure is followed by a deposition step in which a conductive structure made of a conductive material and having a shape which corresponds to the shape of the pattern is generated. For example, if the pattern has the shape of an elongated stripe extending throughout a high step, then an elongated metal trace extending throughout the high step can be fabricated. Therein, the above mentioned reliable exposure leads to a reliable fabrication of an uninterrupted metal trace throughout the step.

Fig. 1 shows a perspective view of a die according to an embodiment of the present invention, having a processed nonplanar surface.

Fig. 2a shows a schematic top view of a wafer being structured perpendicularly so as to have a stepped surface and being suited for the method according to an embodiment of the present invention.

Fig. 2b shows an enlarged top view of a detail of the wafer shown in fig. 2a.

Fig. 2c shows a cross sectional side view of the detail shown in fig. 2b.

Fig. 3 shows a perspective partial view of a die according to a preferred embodiment of the present invention, having a processed wafer surface, illustrating the method according to a preferred embodiment of the present invention.

Fig. 4 shows a perspective view of an Air Probe Focus Sensor for adjusting the focal planes for the exposure steps.

Fig. 5 shows a detailed schematic side view of the Air Probe Focus Sensor of fig. 4.

In the following a detailed description of preferred embodiments of the invention will be given, referring to the drawings.

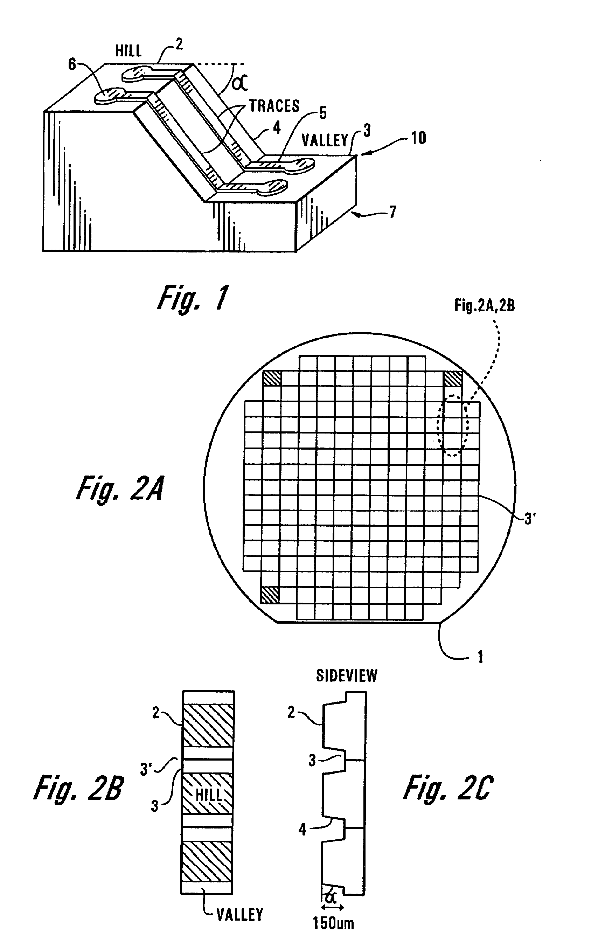

Fig. 1 shows a perspective partial view of a die 7 having a processed nonplanar surface 10, according to a preferred embodiment of the present invention. The surface 10 comprises a single step structure. The surface 10 is thus nonplanar, i.e. comprises different regions not all extending in a single plane. The single step structure comprises a plane top face 2 extending in a first plane, and a plane bottom face 3 extending in a second plane, which extends, in the view of fig. 1, at a lower level than the first plane. The top face 2 and the bottom face 3 are interconnected by a sloping step face 4. The sloping step face 4 is sloping from the top face 2 toward the bottom face 3 at an angle α of about 60°.

The processed surface 10 further comprises two elongated conductive structures 5 and 6 extending continuously from the top face 2 to the bottom face 3, via the sloped step face 4, in an uninterrupted way, according to a preferred embodiment of the present invention.

Fig. 2a shows a schematic top view of a wafer 1 having a wafer surface comprising an array of parallel trenches. Such a wafer 1 is particularly suited for the method according to the present invention. The centers 3' of the bottom faces 3 of the trenches are indicated by crossing straight lines in Fig. 2a. The structure of the trenches can be seen in more detail in figs. 2b and 2c. As is shown in Figs. 2b and 2c, the wafer surface comprises alternating top faces 2 ("hills") extending in a higher first plane and bottom faces 3 ("valleys") extending in a lower second plane. The top faces 2 and the bottom faces 3 have parallel planar surfaces, which have a mutual distance of 150 µm perpendicular to the surfaces. Each particular top face 2 is connected to each adjacent bottom face 3 via a sloping step face 4 (visible in the side view of fig. 2c; not visible in the top view of fig. 2b). The sloping step face 4 is sloping from the top face 2 toward the bottom face 3 at an angle α of about 54.7°. Each bottom face 3 forms the bottom of a trench, with two adjacent sloping step faces 4 forming the side walls of the trench.

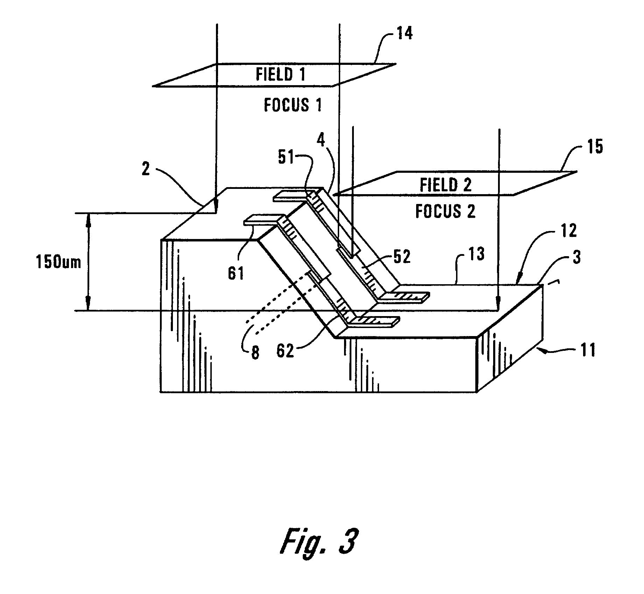

Fig. 3 shows a perspective partial view of a die 11 according to a preferred embodiment of the present invention, having a processed nonplanar wafer surface 12, illustrating the method according to a preferred embodiment of the present invention.

The die 11 of fig. 3 is similar to the die 7 of fig. 1. The die 11 has a processed nonplanar surface 12.

The surface 12 comprises a planar top face 2 extending horizontally in a first plane, a planar bottom face 3 extending parallel to the top face 2 in a second plane, and a sloping step face 4 connecting the top face 2 and the bottom face 3. Fig. 3 also shows two pairs of elongated exposed and developed stripes (51, 52) and (61, 62) in a resist coating 13 on the die 11.

In the following, the fabrication of two conductive traces 5, 6 according to a method according to a preferred embodiment of the present invention will be explained.

The first process step is a resist coating step, in which the surface of the die 11, i.e. the top face 2, the bottom face 3, and the sloping step face 4 are coated by a photosensitive resist 13. A resist is selected which is suited for use with the exposure light used for the following photolithographic exposure.

Next, the photolithographic exposure of the resist follows. Projection lithography using a single mask (not shown) is used for the exposure. The mask comprises a pattern of two parallel elongated stripes.

In a first exposure step, the mask is adjusted parallel to the top face 2 and such that the pattern of the mask is illuminated onto a first exposure field 14 covering the top face 2 and slightly more than the half of the sloping step face 4 adjacent to the top face 2. Therein, the pattern is focused into a first focal plane which coincides with the top face 2. Hence, in the first exposure step, a first mask pattern comprising two stripes 51 and 61 is generated in the resist coating 13 on the top face 2.

In a second exposure step, the mask is adjusted parallel to the bottom face 3 and such that the pattern of the mask is illuminated onto a second exposure field 15 covering the bottom face 2 and slightly more than the half of the sloping step face 4 adjacent to the bottom face 3. Therein, the pattern is focused into a second focal plane which coincides with the bottom face 3. Hence, in the second exposure step, a second mask pattern comprising two stripes 52 and 62 is generated in the resist coating 13 on the bottom face 3.

The stripe 51 and the stripe 52 slightly overlap in a center step region 8 of the sloping step face 4. The stripe 61 and the stripe 62 overlap similarly. The center step region 8 has about the same distance from the top face 2 and from the bottom face 3, respectively.

After the exposure follows a conventional development step, in which the exposed resist is developed so as to transfer the pattern of the stripes 51, 52, 61, 62 into the resist coating 13. Thus, the pattern shown in fig. 3 is generated.

Finally, a deposition step follows, in which a conductive structure made of conductive material and having a shape which corresponds to the shape of the four stripes 51, 52, 61, 62 is generated. Any suitable conventional method can be used for this purpose. For example, first a conductive material is deposited onto the surface. Then, a photolithography process s performed, followed by a lift-off process. Alternatively to the lift-off process, an etching process can be performed after the deposition of the material and the photolithography process.

Finally a conductive stripe 5 has been generated at the location of the stripes 51, 52, and a conductive stripe 6 has been generated at the location of the stripes 61, 62. Any conductive material which can be deposited can be used. For example, a metal or poly-silicon can be used as the conductive material.

While the invention has been described referring to preferred embodiments thereof, further variations of the invention are possible and meant to be covered by the invention.

Generally, the first focal plane and the second focal plane can extend into any direction except for a direction which is exactly perpendicular to the surface to be exposed. This means that the exposure light can be incident onto the surface at any angle from almost parallel to the surface to perpendicular to the surface. Therein, the exposure light can be incident at different angles in the two - or possibly more - different exposure steps.

Preferably, the first focal plane and the second focal plane are mutually parallel. This means that the exposure light is incident at the same angle in both - or all - exposure steps. This way, the resolution is improved and larger surfaces can be reliably exposed.
The two focal planes can have almost any orientation with respect to the surface.

When an entire wafer or a die is exposed, preferably, the first focal plane and the second focal plane both extend parallel to a plane in which the wafer or the die would extend if it were not structured. This means that the exposure light is incident on the wafer or die at right angle. This allows a better resolution and a more simple design of the device used for exposure. In particular, in the case of a stepped surface as the one shown in fig. 3, the exposure is preferably incident at right angle with respect to the top face 2 and the bottom face 3.

The first pattern portion and the second pattern portion should generate an uninterrupted pattern on the surface, so as to generate the complete pattern. For this reason, an exact alignment is necessary in both the first and the second exposure step.

Preferably, the first pattern portion and the second pattern portion are exposed such that they at least partly overlap on the surface. The overlap ensures a reliable exposure of the pattern also in the case of a slight misalignment.

Preferably, the first exposure step and the second exposure step are performed subsequently. In this case the exposure light can be incident at right angle with respect to the unstructured wafer or die, i.e. for example with respect to the bottom face 2 and the top face 3 in the example of fig. 3, in both the first and the second exposure step. This mode of exposure allows a good resolution, also for large exposed areas.

The distance perpendicular to the first and/or second focal plane (along the direction of propagation of the exposure light) between the first focal plane and the second focal plane is typically in the range from 10 to 300 µm, and is typically equal to 150 µm.

The surface which is being exposed can be a stepped surface as described referring to figs. 1-3.

As mentioned above, the optical device used for the exposure has a nonzero depth of focus.

Taking this into account, in the first exposure step, a sharp image of the first pattern portion is generated in a space region around the first focal plane. The top face 2 and the bottom face 3 should have such a mutual distance, the location of the first focal plane should be selected such, and the first exposure field 14 should be selected such, that a sufficient exposure is achieved in the entire first exposure field 14, including the part of the sloping step face 4 which is exposed in the first exposure step.

In the second exposure step, a sharp image of the pattern is generated in a space region around the second focal plane. The top face 2 and the bottom face 3 should now have such a mutual distance, the location of the second focal plane should be selected such, and the second exposure field 15 should be selected such, that a sufficient exposure is achieved in the entire second exposure field 15, including the part of the sloping step face 4 which is exposed in the second exposure step.

In the above configuration, the first focal plane should be spaced closer to the top face 2 than the second focal plane is, and the second focal plane should be spaced closer to the bottom face 3 than the first focal plane is.

As was mentioned before, the first and the second focal plane can have any mutual orientation. However, preferably the first and the second focal plane are parallel.

The first focal plane can have a finite (i.e. nonzero) angle with respect to the top face 2. Preferably, the first focal plane is parallel to the top face 2.

Also, the second focal plane can have a finite (i.e. nonzero) angle with respect to the bottom face 3. Preferably, the first focal plane is parallel to the bottom face 3.

Alternatively, one or both of the first focal plane and the second focal plane can be parallel to the sloping step face 4.

The first focal plane can be located above or below the top face 2. Preferably the first focal plane coincides with the top level of the top face 2.

In the same way, the second focal plane can be located above or below the bottom face 3. Preferably the second focal plane coincides with the bottom level of the bottom face 3.

Preferably, a mask projection technique using UV light as an exposure light and a corresponding UV sensitive resist is used.
Alternatively to using masks, a scanning technique, such as electron beam exposure, can be used.

More than two exposure steps can be performed, if this is required. For example, three or more exposure steps can be performed for photolithographically exposing a surface having very large variations in surface level along the direction of propagation of the exposure light.

For example, for a die being similar to the die 11 of figure 3 but having a larger distance between the top face 2 and the bottom face 3 a three-step exposure can be used. Therein, only the top face 2 is exposed in a first exposure step, only the sloping step face 4 is exposed in a second exposure step, and only the bottom face 3 is exposed in a third exposure step. Of course, the numbering "first, second, third" does not say that the three steps are necessarily performed in the order that the first exposure step is performed first, then the second exposure step, and finally the third exposure step, although the three exposure steps can be performed in that order.
This argumentation also holds for methods comprising only two exposure steps or more than three exposure steps.

Alternatively, if the top face 2 and the bottom face 3 have an even larger mutual distance, with an extended sloping step face 4 inbetween, then several exposure steps can be performed, wherein different surface portions of the sloping step face 4 are exposed. For example, in a first exposure step a first exposure field covering only the top face 2 is exposed. In a second exposure step a second exposure field covering a first step face portion of the sloping step face 4 adjacent to the top face 2 is exposed. In a third exposure step, a third exposure field covering a second step face portion adjacent to the first step face portion is exposed. Further exposure steps can follow. In a further exposure step, a further exposure field covering a last step face portion of the sloping step face 4 adjacent to the bottom face 3 is exposed. Finally, a last exposure step is performed, wherein a last exposure field covering only the bottom face 3 is exposed.

The different exposure steps can be performed such that the exposure fields of each two adjacent surface portions overlap in a region around the border between the two adjacent surface portions. This particular optional feature of the exposure method of the present invention resembles a so-called stitching process which is known for planar surfaces and wherein several exposure steps for exposing several adjacent exposure fields are performed such that adjacent exposure fields overlap.

With regard to a deposition step performed subsequently to the photolithographic exposure, the method of the present invention provides special benefits.

Therein, the reliable photolithographic exposure according to the present invention ensures a reliable fabrication of the conductive structure, without unintended interruptions in the conductive structure.

Usually, not a single die 11 will be processed as described referring to figure 3, but an entire wafer 1 comprising an array of multiple dies 11. In this case, a wafer stepper will be used for the photolithographic exposure.

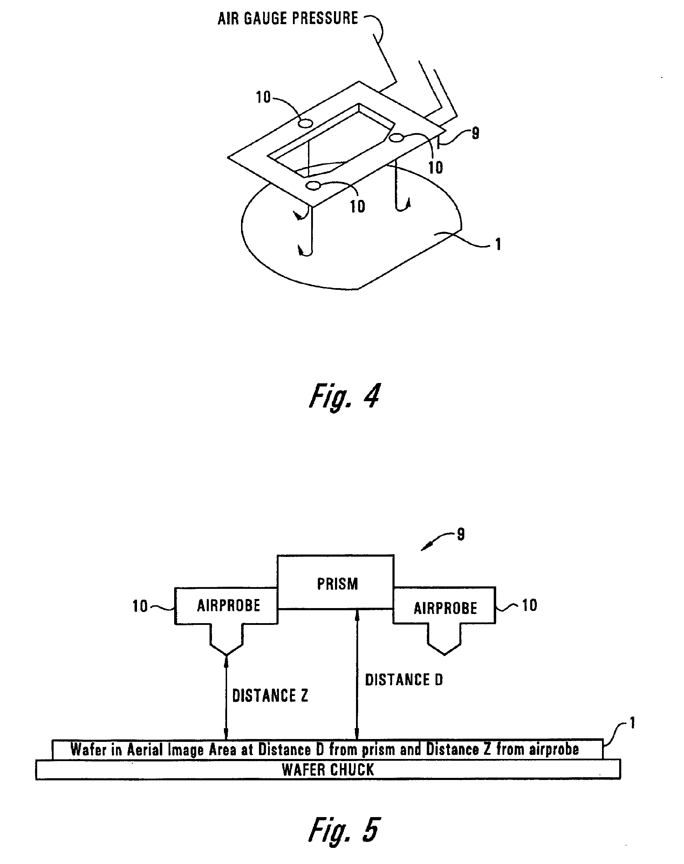

Fig. 4 shows a perspective view of an air probe focus sensor 9 for adjusting the focal planes for the exposure steps and a wafer 1. The air probe focus sensor 9 comprises three air probes 10.

Fig. 5 shows a detailed schematic side view of the air probe focus sensor 9 of fig. 4, together with the wafer 1. Two air probes 10 are visible in fig. 5.

In the following, the use of the air probe focus sensor 9 will be explained at the example of the wafer 1 comprising several dies 11 and being processed according to the method described relating to fig. 3.

For the first exposure step, each air probe 10 is located above a top face 2. Then the exposure device is adjusted, so as to adjust the position of the first focal plane. This adjustment changes the distance of the air probes 10 with respect to the wafer 1. When the air probes 10 detect the top faces 2, a signal is sensed that the first focal plane has reached the correct position for the first exposure step to be performed. Subsequently, the first exposure step is performed.

In this context it should be mentioned that typically air will come out of airprobes, and hit the surface of the die either at the bottom or top plane. The reflected air will be detected by the probes by means of backpressure. The backpressure has calibrated with the distance between the airprobes to the focal plane. Based on the backpressure detected from the reflected air, the position of the wafer is adjusted to place the proper plane within the focal plane area.

For the second exposure step, each air probe 10 is located above a bottom face 3. Then the exposure device is adjusted, so as to adjust the position of the second focal plane. When the air probes 10 detect the bottom faces 3, a signal is sensed that the second focal plane has reached the correct position for the second exposure step to be performed. Subsequently, the second exposure step is performed.

### LEGEND OF REFERENCE SIGNS

- 1: wafer
- 2: top face
- 3: bottom face
- 3': center of the bottom face
- 4: sloped step face
- 5: conductive stripe
- 51: stripe
- 52: stripe
- 6: conductive stripe
- 61: stripe
- 62: stripe
- 7: die (fig. 1)
- 8: center step region
- 9: air probe focus sensor
- 10: surface of die 7
- 11: die (fig. 3)
- 12: surface of die 11
- 13: resist coating
- 14: first exposure field
- 15: second exposure field

- α: angle of the sloped step face 4

## Claims

1. A structuring method, including photolithographically exposing a pattern comprising at least a first pattern portion and a second pattern portion onto a surface, said surface comprising at least a first surface portion at which a tangential plane to the surface extends in a first plane and a second surface portion at which a tangential plane to the surface extends in a second plane not coinciding with the first plane, the method comprising a first exposure step, in which the first pattern portion is exposed, therein being focused into a first focal plane, and a second exposure step, in which the second pattern portion is exposed, therein being focused into a second foal plane which is different from the first focal plane.

2. A structuring method, including photolithographically exposing a pattern comprising at least a first pattern portion and a second pattern portion onto a surface, said surface comprising at least one planar top face extending in a first plane, one planar bottom face extending in an second plane being parallel to and not coinciding with the first plane, and a sloping step face connecting the top face and the bottom face, the method comprising a first exposure step, in which the first pattern portion is exposed onto the top face and at least part of the sloping step face, with the first pattern portion being focused into a first focal plane, and a second exposure step, in which the second pattern portion is exposed onto the bottom face and at least part of the sloping step face, with the second pattern portion being focused into a second focal plane different from the first focal plane.

3. The method according to claim 1 or 2, wherein the first focal plane and the second focal plane are mutually parallel.

4. The method according to claim 1 or 2, wherein the first focal plane extends parallel to the first plane.

5. The method according to claim 1 or 2, wherein the second focal plane extends parallel to the second plane.

6. The method according to claim 1 or 2, wherein the first pattern portion and the second pattern portion are exposed such that they at least partly overlap on the surface.

7. The method according to claim 1 or 2, wherein the first exposure step and the second exposure step are performed subsequently.

8. The method according to claim 2, wherein two different masks are used to expose the first pattern portion and the second pattern portion, respectively.

9. The method according to claim 2, further comprising, after the first and the second exposure step, a deposition step, in which a conductive material is deposited to the surface and further treated, if necessary, so as to generate a conductive structure made of conducting material and having a shape which corresponds to the shape of the pattern.

10. A structuring method according to claim 2, comprising at least one further exposure step, wherein in the further exposure step, a further pattern portion is exposed onto at least part of the sloping step, with the further pattern portion being focused into a further focal plane.

11. The method according to claim 10, wherein at least two out of the first focal plane and the second focal plane and the further focal plane/s are mutually parallel.

12. The method according to claim 10, wherein at least one focal plane out of the first focal plane and the second focal plane and the further focal planes extends parallel to the first or second plane.

13. The method according to any of claims 2 to 12, wherein the first focal plane is spaced closer to the first plane than the second focal plane is, and the second focal plane is spaced closer to the second plane than the first focal plane is.

14. The method according to any preceding claim, wherein the first focal plane coincides with the first plane, and for the second focal plane coincides with the second plane.

15. The method according to claim 10, wherein the further focal plane/s is/are located between the first focal plane and the second focal plane.

16. The method according to claim 10, wherein pattern portion resulting from different exposure steps out of the first, second and further exposure steps and being adjacent to the surface at least partially overlap.

17. The method according to claim 10, wherein pattern portions resulting from different exposure steps out of the first, second and further exposure steps and being adjacent on the surface have an overlap of from 1 to 5 µm.

18. The method according to claim 10, wherein at least two out of the first exposure step, the second exposure step, and the further exposure step/s are performed subsequently.

19. The method according to any preceding claim, wherein the distance perpendicular to the first or second f9ocal plane between the first focal plane and the second focal plane is 150 µm.

20. The method according to claim 10, wherein a different mask is used to expose each of the first pattern portion, the second pattern portion, and the further pattern portion/s, respectively.

21. The method according to claim 10, wherein the first pattern portion and the second pattern portion are exposed such that they at least partly overlap on the surface, and, further comprising, after the first and the second exposure step, a deposition step, in which a conductive material is deposited to the surface so as so generate a conductive structure made of conducting material and having a shape which corresponds to the shape of the pattern.

22. A structuring method, including photolithographically exposing a pattern comprising at least a first pattern portion and a second pattern portion onto a surface extending in a surface plane and being structured perpendicular to the surface plane, the method comprising a resist coating step, in which the surface is coated by a photosensitive resist, a first exposure step, in which the first pattern portion is exposed into the resist, therein being focused into a first focal plane, a second exposure step, in which the second pattern portion is exposed into the resist, therein being focused into a second focal plane which is different from the first focal plane, a development step, in which the exposed resist is developed so as to transfer the pattern into the resist, and a deposition step, in which a conductive material is deposited to the surface and further treated, if necessary, so as to generate a conductive structure made of conducting material and having a shape which corresponds to the shape of the pattern.

23. A structuring method, including photolithographically exposing a pattern comprising at least a first pattern portion and a second pattern portion onto a surface extending in a surface plane and being structured perpendicular to the surface plane, the method comprising a deposition step, in which a conductive material is deposited to the surface, a resist coating step, in which the surface is coated by a photosensitive resist, a first exposure step, in which the first pattern portion is exposed into the resist, therein being focused into a first focal plane, a second exposure step, in which the second pattern portion is exposed into the resist, therein being focused into a second focal plane which is different from the first focal plane, a development step, in which the exposed resist is developed so as to transfer the pattern into the resist, and an etching step, in which the exposed material not covered by the resist is etched.
